# EUROPEAN PATENT APPLICATION

(11) **EP 4 084 084 A1**
(43) Date of publication of application: **02.11.2022**
(21) Application number: 20907435.0
(22) Date of filing: 10.04.2020
(51) Int. Cl.: H01L 29/739

(54) **CELLULAR STRUCTURE OF REVERSE CONDUCTION IGBT AND REVERSE CONDUCTION IGBT**

(30) Priority: 26.12.2019 CN 201911366131
(71) Applicant: Zhuzhou CRRC Times Semiconductor Co. Ltd, Zhuzhou, Hunan 412005 (CN)
(72) Inventor: LUO, Haihui, Zhuzhou, Hunan 412005 (CN); XIAO, Qiang, Zhuzhou, Hunan 412005 (CN); ZHU, Liheng, Zhuzhou, Hunan 412005 (CN); QIN, Rongzhen, Zhuzhou, Hunan 412005 (CN); LIU, Pengfei, Zhuzhou, Hunan 412005 (CN)
(74) Representative: Petraz, Gilberto Luigi
(86) International application number: PCT/CN2020/084136
(87) International publication number: WO 2021/128653

(57) **Abstract**

Provided are a cellular structure (300) of a reverse conduction IGBT and the reverse conduction IGBT. The cellular structure (300) comprises: a second conductivity type well region (303) located in the center of the cellular structure; first conductivity type source regions (305) and a second conductivity type source region (304) that are arranged in the well region surface, wherein the first conductivity type source regions (305) are located on two sides of the second conductivity type source region (304), parts of the first conductivity type source regions cover parts of the surfaces on two sides of the second conductivity type source region (304), and the side faces of the first conductivity type source regions (305) and the surface, which is not covered with the first conductivity type source regions (305), of the second conductivity type source region (304) jointly define a main trench; a conductive layer (308) covering the sidewall and the bottom of the main trench; and an emitter metal layer (310) arranged on a gate structure and in the main trench, wherein a part of the conductive layer (308) at the bottom of the main trench is in contact with the emitter metal layer (310). The structure can reduce the effect of the gate voltage on the forward conduction voltage drop of the FRD in the reverse conduction IGBT, such that the FRD obtains a lower forward voltage drop.

## Description

The present disclosure claims the priority of Chinese patent application No. 201911366131.0, filed on December 26, 2019 and entitled "Cellular structure of reverse conducting IGBT and reverse conducting IGBT", which is incorporated herein by reference in its entirety.

### Field of the Invention

The disclosure relates to the technical field of semiconductor devices, and in particular to a cellular structure of a reverse conducting IGBT and a reverse conducting IGBT.

### Background of the Invention

An insulated gate bipolar transistor (IGBT) is a composite fully-controlled voltage-drive power semiconductor device formed by a bipolar junction transistor (BJT) and a metal-oxide-semiconductor field-effect transistor (MOSFET), and has become a kind of semiconductor device that is used most widely in large-voltage, large-current and highfrequency power electronic applications. In the application of the IGBT, it is usually necessary to connect a fast recovery diode (FRD) of a corresponding specification in antiparallel as a current bleeding circuit when the IGBT is turned off, so as to protect an IGBT chip. For consideration of reducing the cost and reducing various parasitic effects caused by packaging, the IGBT and the FRD can be integrated in the same chip, i.e. a reverse conducting IGBT (RC-IGBT).

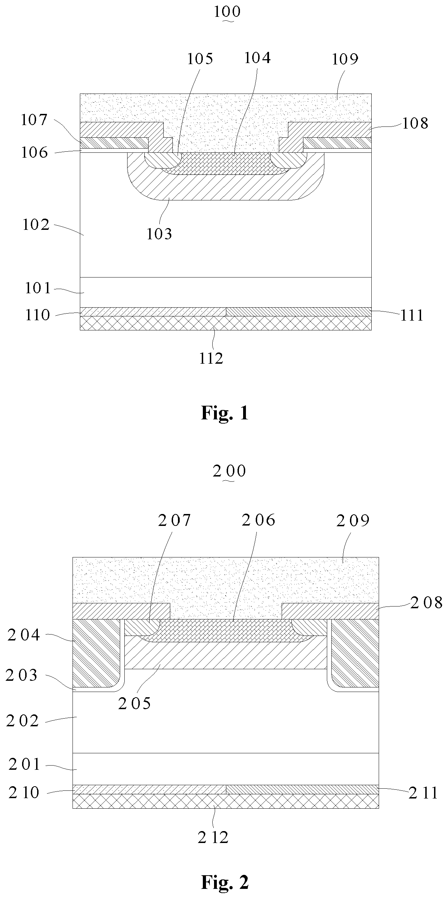

As shown in Figs. 1 and2, a traditional cellular structure of a reverse conducting IGBT integrates functions of the IGBT device and the FRD device, and when the reverse conducting IGBT works in an FRD mode, a change in the gate voltage strongly affects the performance of the FRD. When the gate voltage of the reverse conducting IGBT is less than or equal to 0 V, the reverse conducting IGBT does not form a reverse carrier channel, an anode of the FRD is not short-circuited, the anode injection efficiency of the FRD is high, and a forward turn-on voltage drop of the FRD is relatively low. However, when the gate voltage of the reverse conducting IGBT is greater than or equal to a threshold voltage, a reverse carrier channel is formed between two source regions that have opposite conductivity types in the reverse conducting IGBT, which short circuits the anode of the FRD, causing the decrease of the anode injection efficiency of the FRD and the increase of the forward turn-on voltage drop of the FRD, such that the FRD cannot normally work.

### Summary of the Invention

For the above-mentioned problems, the disclosure provides a cellular structure of a reverse conducting IGBT and a reverse conducting IGBT.

In a first aspect, the disclosure provides a cellular structure of a reverse conducting IGBT, the cellular structure including:
a first conductivity type substrate;
a first conductivity type drift region located on the substrate;
a second conductivity type well region located in the center of the cellular structure and arranged in a surface of the drift region;
first conductivity type source regions and a second conductivity type source region that are arranged in a surface of the well region, where the first conductivity type source regions are located at opposite sides of the second conductivity type source region and the first conductivity type source regions are higher than the second conductivity type source region, such that parts of bottoms of the first conductivity type source regions cover parts of surfaces at opposite sides of the second conductivity type source region, and side faces of the first conductivity type source regions and a part of the surface, which is not covered with the first conductivity type source regions, of the second conductivity type source region jointly define a main trench;
a conductive layer covering a sidewall and a bottom of the main trench;
gate structures arranged at opposite sides of the main trench and in contact with the well region and the first conductivity type source regions; and
an emitter metal layer arranged on the gate structures and in the main trench,
wherein isolation is established between grids in the gate structures and the first conductivity type source regions, between the grids in the gate structures and a part of the conductive layer on the sidewall of the main trench, and between the grids in the gate structures, the first conductivity type source regions and a part of the conductive layer on the sidewall of the main trench and the emitter metal layer, by means of interlayer dielectric layers, and a part of the conductive layer at the bottom of the main trench is in contact with the emitter metal layer, for exporting a current of the first conductivity type source regions.

According to the embodiments of the disclosure, preferably, the surface of the second conductivity type source region is lower than the surface of the first conductivity type source regions by more than 0.3 µm.

According to the embodiments of the disclosure, preferably, the conductive layer is a metal layer or a silicon alloy layer.

According to the embodiments of the disclosure, preferably, the cellular structure further includes:
a first conductivity type storage region arranged in the drift region and located below the well region.

According to the embodiments of the disclosure, preferably, the doping concentration of the storage region is higher than the doping concentration of the substrate by one to two orders of magnitude.

According to the embodiments of the disclosure, preferably, the cellular structure further includes:
a lifetime control region arranged in the well region and located below the second conductivity type source region.

According to the embodiments of the disclosure, preferably, the gate structure comprises a gate insulating layer located on the drift layer and in contact with surfaces of the first conductivity type source regions, the well region and the drift layer concurrently, and a grid located on the gate insulating layer.

According to the embodiments of the disclosure, preferably, the gate structure comprises a gate trench arranged in the drift layer and adjacent to the well region, a gate insulating layer arranged on a sidewall and the bottom of the gate trench, and a grid filling the gate trench, where the gate trench is also in contact with one end of the first conductivity type source regions that is distal from the cellular structure.

According to the embodiments of the disclosure, preferably, the cellular structure further includes:
a second conductivity type collector region located below the substrate, and a first conductivity type short circuit region adjacent to the collector region; and
a collector metal layer located below the collector region and the short circuit region and electrically connected to the collector region and the short circuit region.

According to the embodiments of the disclosure, preferably, the cellular structure is a honeycomb cellular structure or a strip-shaped cellular structure.

In a second aspect, the disclosure provides a reverse conducting IGBT device, including several cellular structures of a reverse IGBT according to any one of the first aspect.

By utilizing the above-mentioned solutions, at least the following advantageous effects can be achieved.

The disclosure provides a cellular structure of a reverse conducting IGBT and the reverse conducting IGBT. The first conductivity type source regions are connected to the emitter metal layer by means of a conductive layer, such that a coupling relationship between the first conductivity type source regions and the second conductivity type source region is removed; and the current of the first conductivity type source regions is exported by means of the conductive layer, such that when the reverse conducting IGBT works in the FRD mode and the gate voltage of the reverse conducting IGBT is greater than or equal to the threshold voltage, the influence of a short circuit effect of the first conductivity type source regions on FRD anode injection is reduced, so as to reduce the influence of the gate voltage on the forward turn-on voltage drop of the FRD, and thus the FRD obtains a lower forward voltage drop.

### Brief Description of the Drawings

The accompanying drawings are used for providing a further understanding of the disclosure and constitute a part of this description, and are used, together with the following particular implementations, for explaining the present application but do not limit the disclosure. In the drawings:
Fig. 1 is a schematic cross-sectional view of a traditional cellular structure of a reverse conducting IGBT that is of a plane gate structure;
Fig. 2 is a schematic cross-sectional view of a traditional cellular structure of a reverse conducting IGBT that is of a trench gate structure;
Fig. 3 is a schematic cross-sectional view of a cellular structure of a reverse conducting IGBT that is of a plane gate structure as shown in an exemplary embodiment of the disclosure;
Fig. 4 is a schematic cross-sectional view of a cellular structure of a reverse conducting IGBT that is of another plane gate structure as shown in an exemplary embodiment of the disclosure;
Fig. 5 is a schematic cross-sectional view of a cellular structure of a reverse conducting IGBT that is of another plane gate structure as shown in an exemplary embodiment of the disclosure;
Fig. 6 is a schematic cross-sectional view of a cellular structure of a reverse conducting IGBT that is of a trench gate structure as shown in an exemplary embodiment of the disclosure;
Fig. 7 is a schematic cross-sectional view of a cellular structure of a reverse conducting IGBT that is of another trench gate structure as shown in an exemplary embodiment of the disclosure; and
Fig. 8 is a schematic cross-sectional view of a cellular structure of a reverse conducting IGBT that is of another trench gate structure as shown in an exemplary embodiment of the disclosure.

### Detailed Description of the Embodiments

Implementations of the disclosure will be described below in detail with reference to the accompanying drawings and the embodiments, so as to provide a thorough understanding and practice of an implementation process of how to apply technical means to solve the technical problems and achieve technical effects in the disclosure. The embodiments of the disclosure and various features in the embodiments can be combined with one another in the absence of conflict, and the technical solutions thus formed shall fall within the scope of protection of the disclosure. In the accompanying drawings, the dimensions and relative dimensions of layers and regions may be exaggerated for clarity. Throughout the drawings, a similar element is provided with the same reference number.

It should be understood that although terms "first", "second", "third", etc. can be used to describe various elements, components, regions, layers and/or parts, these elements, components, regions, layers and/or parts should not be limited by these terms. There terms are merely used for distinguishing one element, component, region, layer or part from another element, component, region, layer or part. Therefore, without departing from the teaching of the disclosure, the first element, component, region, layer or part discussed below can be represented as a second element, component, region, layer or part.

It should be understood that the spatial relationship terms such as "on", "located on", "below" and "located below" can be used herein for the ease of description, so as to describe the relationship between one element or feature as shown in the figure and another element or feature. It should be understood that the spatial relationship terms are intended to further include using an orientation different from that of the device during operation, in addition to the orientation as shown in the figures. For example, if the device in the accompanying drawing is turned over, the element or feature described as "below another element" will be oriented to be "on" another element or feature. Therefore, the exemplary terms "located below" and "below" can include two orientations, i.e., on and below. The device can be additionally oriented (rotated by 90 degrees or in other orientations), and the spatial relationship terms used herein are explained correspondingly.

The objective of the terms used herein is merely to describe the particular embodiments rather than limiting the disclosure. When used herein, the singular forms "a", "an" and "said/the" are also intended to include the plural forms, unless the context clearly indicates otherwise. It should also be understood that the terms "form" and/or "include", when used in the description, specify the presence of the features, integers, steps, operations, elements and/or components, but do not exclude the presence or addition of one or more other features, integers, steps, operations, elements, components and/or a combination of them. When used herein, the term "and/or" includes any and all combinations of associated items that are listed.

The embodiments of the disclosure are described herein with reference to the transverse cross-sectional view of the schematic diagram as an ideal embodiment (and an intermediate structure) of the disclosure. In this way, it is possible to expect a change in the shown shape caused by, for example, the preparation technique and/or tolerance. Therefore, the embodiments of the disclosure should not be limited to the specified shape of the regions as shown herein, but include a shape deviation caused by, for example, preparation. For example, an injection region shown as rectangular usually has a circular or curved feature and/or an injection concentration gradient at the edge thereof, rather than a binary change from an injection region to a non-injection region. Similarly, a buried region formed by injection can cause some injection in a region between the buried region and a surface passed by when injection is performed. Therefore, the regions shown in the figures are substantially illustrative, the shapes of them are not intended to show the actual shapes of the regions of the device, and are not intended to limit the scope of the disclosure.

For thorough understanding of the disclosure, the detailed structure and steps will be provided in the following description, so as to facilitate the explanation of the technical solution disclosed in the disclosure. The preferred embodiments of the disclosure are described in detail as follows. However, in addition to this detailed description, the disclosure can also have other implementations.

### Embodiment one

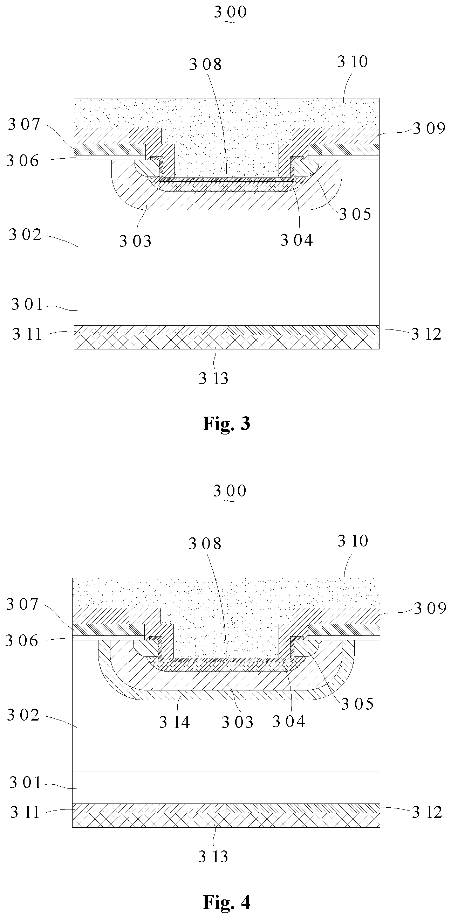

As shown in Fig. 3, the embodiment of the disclosure provides a cellular structure 300 of a reverse conducting IGBT that is of a plane gate structure. The cellular structure includes a substrate 301, a drift layer 302, a well region 303, a second conductivity type source region 304, first conductivity type source regions 305, a gate insulating layer 306, a grid 307, a conductive layer 308, an interlayer dielectric layer 309, an emitter metal layer 310, a collector region 311, a short circuit region 312 and a collector metal layer 313.

The substrate 301 is exemplarily a first conductivity type silicon-based substrate.

The drift layer 302 is a first conductivity type drift layer and is located on the substrate 301. The thickness of the drift layer 302 is selected according to a pressure-tolerant capability of a device.

The well region 303 is a second conductivity type well region, and is located in the center of the cellular structure and arranged in a surface of the drift layer 302. A surface of the well region 303 is flush with the surface of the drift region 302.

The second conductivity type source region 304 is a second conductivity type source region, and is arranged in the surface of the well region 303.

The first conductivity type source regions 305 are first conductivity type source regions. The first conductivity type source regions 305 are arranged in the surface of the well region 303 and located at opposite sides of the second conductivity type source region 304. The first conductivity type source regions 305 are higher than the second conductivity type source region 304, such that parts of the bottom of the first conductivity type source regions 305 cover parts of the surfaces at the opposite sides of the second conductivity type source region 304, and the side faces of the first conductivity type source regions 305 and the surface, which is not covered with the first conductivity type source regions 305, of the second conductivity type source region 304 jointly define a main trench (not labeled in the figures).

In the embodiment, the above-mentioned main trench is obtained by etching a part of the second conductivity type source region 304 between two first conductivity type source regions 305 after the first conductivity type source regions 305 and the second conductivity type source region 304 are formed in the surface of the well region 303. After etching, only a part, which is located below the first conductivity type source regions 305 and below the main trench, of the second conductivity type source region 304 remains.

In the embodiment, the surface of second conductivity type source region 304 is more than 0.3 µm lower than the surface of first conductivity type source regions 305. Such structure can improve the injection level of carriers in a vertical direction.

The gate insulating layer 306 and the grid 307 form a gate structure. In the embodiment, the gate structure is a plane gate structure.

The gate insulating layer 306 is located at opposite sides of the main trench and located on the drift layer 302. The gate insulating layer 306 is in contact with surfaces of the first conductivity type source regions 305, the well region 303 and the drift layer 302 at the same time, but is not in contact with the conductive layer 308. The gate insulating layer 306 isolates the grid 307 from the first conductivity type source regions 305, the well region 303 and the drift layer 302.

The grid 307 is a polysilicon grid, and is arranged on the gate insulating layer 306.

The conductive layer 308 is arranged on the bottom and a sidewall of the above-mentioned main trench, and even extends to on the first conductivity type source regions 305. The thickness of the conductive layer 308 is 50 nm to 200 nm, and the conductive layer 308 is a metal layer or a silicon alloy layer.

The interlayer dielectric layer 309 is located on the grid 307, and covers parts of the conductive layer that are located on the first conductivity type source regions 305 and located on the sidewall of the main trench. The interlayer dielectric layer 309 isolates the grid 307, the first conductivity type source regions 305, and the parts of the conductive layer that are located on the first conductivity type source regions 305 and located on the sidewall of the main trench from the emitter metal layer 310, and also isolates the grid 307 from the first conductivity type source regions 305 and the conductive layer 308.

The emitter metal layer 310 is located on the interlayer dielectric layer 309 and fills the above-mentioned main trench. The emitter metal layer 310 is in contact with a part of the conductive layer that is located on the bottom of the main trench, and is used for exporting a short circuit current of the first conductivity type source regions 305. The emitter metal layer 310 can be metal such as aluminum, which has low contact resistivity.

Through such structure, the reverse conducting IGBT works in the FRD mode, and when the gate voltage of the reverse conducting IGBT is greater than or equal to the threshold voltage, the short circuit current of the first conductivity type source regions 305 is exported via the conductive layer 308, such that the influence of the short circuit current on the injection of the second conductivity type source region 304 is reduced, and the influence of a short circuit effect of the first conductivity type source regions 305 on FRD anode injection is reduced, thereby achieving the aim of reducing a forward turn-on voltage drop of the FRD.

The collector region 311 is a second conductivity type collector region, and the collector region 311 is located below the substrate 301.

The short circuit region 312 is a second conductivity type short circuit region, and the short circuit region 312 is located below the substrate 301 and adjacent to the collector region 311.

The collector metal layer 313 is located below the collector region 311 and the short circuit region 312, and is electrically connected to the collector region 311 and the short circuit region 312.

In the embodiment, as shown in Fig. 4, the cellular structure 300 can further include a storage region 314. The storage region 314 is a first conductivity type carrier storage region, and is arranged in the drift layer 302 and located below the well region 303. The doping concentration of the storage region 314 is one to two orders of magnitude higher than the doping concentration of the substrate 301. The storage region 314 can reduce the turn-on voltage drop of the IGBT.

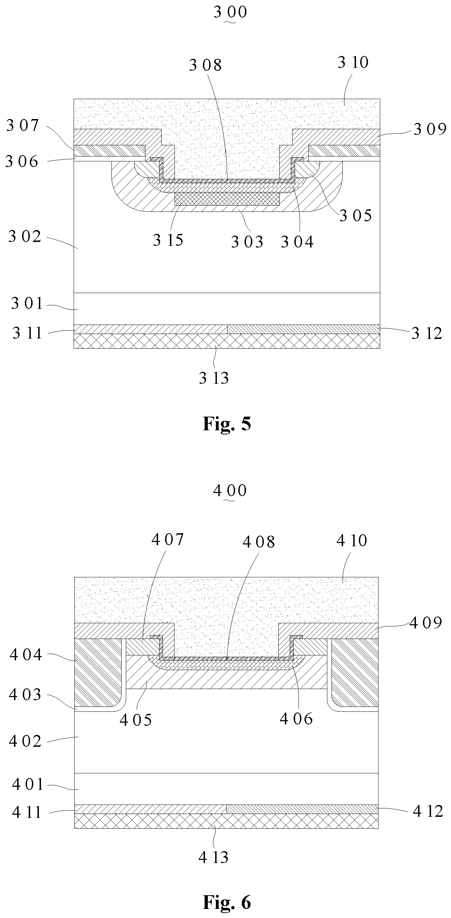

As shown in Fig. 5, the cellular structure 300 can further include a lifetime control region 315. The lifetime control region 315 is arranged in the well region 303 and located below the second conductivity type source region 304. The lifetime control region 315 is a low lifetime control region, and the minority carrier lifetime thereof is generally three to four orders of magnitude lower than that of the other regions. The lifetime control region 315 is obtained by injecting other types of impurities into the well region to reduce the minority carrier lifetime, such that a switching loss of the FRD can be reduced. Through such cellular structure, both a lower forward turn-on voltage drop of the FRD and a lower switching loss of the FRD can be obtained.

It should be noted that the shape of the cellular structure 300 can be honeycomb, short-strip-shaped (the cellular length ≤ 200 µm) or long-strip-shaped.

In the embodiment, the first conductivity type and the second conductivity type are opposite to each other. For example, the second conductivity type is the P type when the first conductivity type is the N type; and the second conductivity type is the N type when the first conductivity type is the P type. Specifically, it is merely necessary to make a rational choice according to the type of device that is actually required to be prepared.

The disclosure provides a cellular structure of a reverse conducting IGBT that is of a plane gate structure. The first conductivity type source regions 305 are connected to the emitter metal layer 310 by means of the conductive layer 308, such that a coupling relationship between the first conductivity type source regions 305 and the second conductivity type source region 304 is removed; and the current of the first conductivity type source regions 305 is exported by means of the conductive layer 308, such that when the reverse conducting IGBT works in the FRD mode and the gate voltage of the reverse conducting IGBT is greater than or equal to the threshold voltage, the influence of a short circuit effect of the first conductivity type source regions on FRD anode injection is reduced, so as to reduce the influence of the gate voltage on the forward turn-on voltage drop of the FRD, and thus the FRD obtains a lower forward voltage drop.

### Embodiment two

As shown in Fig. 6, the embodiment of the disclosure provides a cellular structure 400 of a reverse conducting IGBT that is of a trench gate structure. The cellular structure includes a substrate 401, a drift layer 402, a gate insulating layer 403, a grid 404, a well region 405, a second conductivity type source region 406, first conductivity type source regions 407, a conductive layer 408, an interlayer dielectric layer 409, an emitter metal layer 410, a collector region 411, a short circuit region 412 and a collector metal layer 413.

The substrate 401 is exemplarily a first conductivity type silicon-based substrate.

The drift layer 402 is a first conductivity type drift layer and is located on the substrate 401. The thickness of the drift layer 402 is selected according to a pressure-tolerant capability of a device.

A gate trench gate (not labeled in the figures), the insulating layer 403 and the grid 404 form a gate structure. In the embodiment, the gate structure is a trench gate structure.

The gate trench is arranged at opposite sides of the cellular structure, and located in the drift layer 402 and adjacent to the well region 405. The depth of the gate trench is greater than the depth of the well region 405.

The gate insulating layer 403 is arranged on a sidewall and the bottom of the above-mentioned gate trench, and isolates the grid 404 from the first conductivity type source regions 407, the well region 405 and the drift layer 402.

The grid 404 is a polysilicon grid, and fills the above-mentioned gate trench.

The well region 405 is a second conductivity type well region, and is arranged in a surface of the drift layer 402 and located at the central position of the cellular structure and between two gate trenches. A surface of the well region 405 is flush with the surface of the drift layer 402. Two ends of the well region 405 are respectively in contact with the gate trenches at the opposite sides, that is, in contact with the gate insulating layers at the opposite sides.

The second conductivity type source region 406 is a second conductivity type source region, and is arranged in the surface of the well region 405. A surface of the second conductivity type source region 406 is flush with the surface of the drift layer 402.

The first conductivity type source regions 407 are first conductivity type source regions. The first conductivity type source regions 407 are arranged in the surface of the well region 405 and located at opposite sides of the second conductivity type source region 406. The first conductivity type source regions 407 are higher than the second conductivity type source region 406, such that parts of the bottom of the first conductivity type source regions 407 cover parts of the surfaces at the opposite sides of the second conductivity type source region 406, and the side faces of the first conductivity type source regions 407 and the surface, which is not covered with the first conductivity type source regions 407, of the second conductivity type source region 406 jointly define a main trench (not labeled in the figures).

In the embodiment, the above-mentioned main trench is obtained by etching a part of the second conductivity type source region 406 between two first conductivity type source regions 407 after the first conductivity type source regions 407 and the second conductivity type source region 406 are formed in the surface of the well region 405. After etching, only a part, which is located below the first conductivity type source regions 407 and below the main trench, of the second conductivity type source region 406 remains.

In the embodiment, the surface of second conductivity type source region 406 is more than 0.3 µm lower than the surface of first conductivity type source regions 407. Such structure can improve the injection level of carriers in a vertical direction.

The conductive layer 408 is arranged on the bottom and a sidewall of the above-mentioned main trench, and even extends to on the first conductivity type source regions 407. The thickness of the conductive layer 408 is 50 nm to 200 nm, and the conductive layer 408 is a metal layer or a silicon alloy layer.

The interlayer dielectric layer 409 is located on the grid 404, and covers both the first conductivity type source regions 407 and parts of the conductive layer that are located on the first conductivity type source regions 407 and located on the sidewall of the main trench. The interlayer dielectric layer 409 isolates the grid 404, the first conductivity type source regions 407, and the parts of the conductive layer that are located on the first conductivity type source regions 407 and located on the sidewall of the main trench from the emitter metal layer 410, and also isolates the grid 404 from the first conductivity type source regions 407 and the conductive layer 408.

The emitter metal layer 410 is located on the interlayer dielectric layer 409 and fills the above-mentioned trench. The emitter metal layer 410 is in contact with the conductive layer that is located on the bottom of the main trench, and is used for exporting a short circuit current of the first conductivity type source regions 407. The emitter metal layer 410 can be metal such as aluminum, which has low contact resistivity.

Through such structure, the reverse conducting IGBT works in the FRD mode, and when the gate voltage of the reverse conducting IGBT is greater than or equal to the threshold voltage, the short circuit current of the first conductivity type source regions 407 is exported via the conductive layer 408, such that the influence of the short circuit current on the injection of the second conductivity type source region 406 is reduced, and the influence of a short circuit effect of the first conductivity type source regions 407 on FRD anode injection is reduced, thereby achieving the aim of reducing a forward turn-on voltage drop of the FRD

The collector region 411 is a second conductivity type collector region, and the collector region 411 is located below the substrate 401.

The short circuit region 412 is a second conductivity type short circuit region, and the short circuit region 412 is located below the substrate 401 and adjacent to the collector region 411.

The collector metal layer 413 is located below the collector region 411 and the short circuit region 412, and is electrically connected to the collector region 411 and the short circuit region 412.

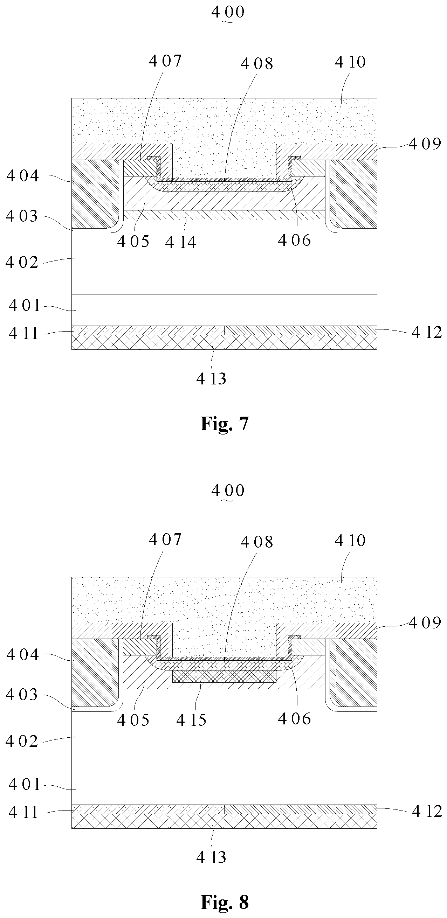

In the embodiment, as shown in Fig. 7, the cellular structure 400 can further include a storage region 414. The storage region 414 is a first conductivity type carrier storage region, and is arranged in the drift layer 402 and located below the well region 405. The doping concentration of the storage region 414 is one to two orders of magnitude higher than the doping concentration of the substrate 401. The storage region 414 can reduce the turn-on voltage drop of the IGBT.

As shown in Fig. 8, the cellular structure 400 can further include a lifetime control region 415. The lifetime control region 415 is arranged in the well region 405 and located below the second conductivity type source region 406. The lifetime control region 415 is a low lifetime control region, and the minority carrier lifetime thereof is generally three to four orders of magnitude lower than that of the other regions. The lifetime control region 415 is obtained by injecting other types of impurities into the well region to reduce the minority carrier lifetime, such that a switching loss of the FRD can be reduced. Through such cellular structure, both a lower forward turn-on voltage drop of the FRD and a lower switching loss of the FRD can be obtained.

It should be noted that the shape of the cellular structure 400 can be honeycomb, short-strip-shaped (the cellular length ≤ 200 µm) or long-strip-shaped.

In the embodiment, the first conductivity type and the second conductivity type are opposite to each other. For example, the second conductivity type is the P type when the first conductivity type is the N type; and the second conductivity type is the N type when the first conductivity type is the P type. Specifically, it is merely necessary to make a rational choice according to the type of device that is actually required to be prepared.

The disclosure provides a cellular structure of a reverse conducting IGBT that is of a plane gate structure. The first conductivity type source regions 407 are connected to the emitter metal layer 410 by means of the conductive layer 408, such that a coupling relationship between the first conductivity type source regions 407 and the second conductivity type source region 406 is removed; and the current of the first conductivity type source regions 407 is exported by means of the conductive layer 408, such that when the reverse conducting IGBT works in the FRD mode and the gate voltage of the reverse conducting IGBT is greater than or equal to the threshold voltage, the influence of a short circuit effect of the first conductivity type source regions 407 on FRD anode injection is reduced, so as to reduce the influence of the gate voltage on the forward turn-on voltage drop of the FRD, and thus the FRD obtains a lower forward voltage drop.

The foregoing description is merely illustrative of the preferred embodiments of the disclosure and is not used for limiting the disclosure, and various changes and modifications may be made to the disclosure by those skilled in the art. Within the spirit and principle of the disclosure, any modifications, equivalent replacements, improvements, etc., shall be contained within the scope of protection of the disclosure. The implementations disclosed by the disclosure are as stated above, but the content is only implementations used for facilitating the understanding of the disclosure, rather than being used for limiting the disclosure. Any of those skilled in the technical field to which the disclosure belongs can make any modification and change to the form and details of the implementation without departing from the spirit and scope of the disclosure, but the scope of protection of the disclosure shall be defined in the appended claims.

## Claims

1. A cellular structure of a reverse conduction IGBT, comprising:
a first conductivity type substrate;
a first conductivity type drift region located on the substrate;
a second conductivity type well region located in the center of the cellular structure and arranged in a surface of the drift region;
first conductivity type source regions and a second conductivity type source region that are arranged in a surface of the well region, wherein the first conductivity type source regions are located at opposite sides of the second conductivity type source region and the first conductivity type source regions are higher than the second conductivity type source region, such that parts of bottoms of the first conductivity type source regions cover parts of surfaces at the opposite sides of the second conductivity type source region, and side faces of the first conductivity type source regions and a part of the surface, which is not covered with the first conductivity type source regions, of the second conductivity type source region jointly define a main trench;
a conductive layer covering a sidewall and a bottom of the main trench;
gate structures arranged on opposite sides of the main trench and in contact with the well region and the first conductivity type source regions; and
an emitter metal layer arranged on the gate structures and in the main trench,
wherein isolation is established between grids in the gate structures and the first conductivity type source regions, between the grids in the gate structures and a part of the conductive layer on the sidewall of the main trench, and between the grids in the gate structures, the first conductivity type source regions and a part of the conductive layer on the sidewall of the main trench and the emitter metal layer, by means of interlayer dielectric layers, and a part of the conductive layer at the bottom of the main trench is in contact with the emitter metal layer, for exporting a current of the first conductivity type source regions.

2. The cellular structure of a reverse conduction IGBT according to claim 1, wherein the surface of the second conductivity type source region is lower than the surface of the first conductivity type source regions by more than 0.3 µm.

3. The cellular structure of a reverse conduction IGBT according to claim 1, **characterized in that** the conductive layer is a metal layer or a silicon alloy layer.

4. The cellular structure of a reverse conduction IGBT according to claim 1, **characterized in that** the cellular structure further comprises:
a first conductivity type storage region arranged in the drift region and located below the well region.

5. The cellular structure of a reverse conduction IGBT according to claim 4, wherein the doping concentration of the storage region is higher than the doping concentration of the substrate by one to two orders of magnitude.

6. The cellular structure of a reverse conduction IGBT according to claim 1, further comprising:
a lifetime control region arranged in the well region and located below the second conductivity type source region.

7. The cellular structure of a reverse conduction IGBT according to claim 1, wherein the gate structure comprises a gate insulating layer located on the drift layer and in contact with surfaces of the first conductivity type source regions, the well region and the drift layer concurrently, and a grid located on the gate insulating layer.

8. The cellular structure of a reverse conduction IGBT according to claim 1, wherein the gate structure comprises a gate trench arranged in the drift layer and adjacent to the well region, a gate insulating layer arranged on a sidewall and the bottom of the gate trench, and a grid filling the gate trench, wherein the gate trench is also in contact with one end of the first conductivity type source regions that is distal from the cellular structure.

9. The cellular structure of a reverse conduction IGBT according to claim 1, further comprising:
a second conductivity type collector region located below the substrate, and a first conductivity type short circuit region adjacent to the collector region; and
a collector metal layer located below the collector region and the short circuit region and electrically connected to the collector region and the short circuit region.

10. The cellular structure of a reverse conduction IGBT according to claim 1, wherein the cellular structure is a honeycomb cellular structure or a strip-shaped cellular structure.

11. A reverse conduction IGBT device, comprising the cellular structure of a reverse IGBT according to any one of claims 1 to 10.
